# EUROPÄISCHE PATENTSCHRIFT

(11) **EP 0 993 761 B1**
(45) Veröffentlichungstag und Bekanntmachung des Hinweises auf die Patenterteilung: **21.08.2002**
(21) Anmeldenummer: 98936252.0
(22) Anmeldetag: 25.06.1998
(51) Int. Cl.: H05K 13/04

(54) **VERFAHREN UND VORRICHTUNG ZUR MESSUNG DER HÖHENPOSITION VON OBJEKTKANTEN VON BAUELEMENTEN**
METHOD AND DEVICE FOR MEASURING THE HEIGHT AT WHICH OBJECT EDGES OF COMPONENTS ARE POSITIONED
DISPOSITIF ET PROCEDE DE MESURE DE LA POSITION EN HAUTEUR DE CONNEXIONS DE COMPOSANTS

(30) Priorität: 30.06.1997 DE 19727809
(43) Veröffentlichungstag der Anmeldung: 19.04.2000
(73) Patentinhaber: SIEMENS AKTIENGESELLSCHAFT, 80333 München (DE)
(72) Erfinder: BRODT, Michael, D-82256 Fürstenfeldbruck (DE); STANZL, Harald, D-81476 München (DE); STOCKMANN, Michael, D-83052 Bruckmühl (DE)
(86) Internationale Anmeldenummer: DE9801752
(87) Internationale Veröffentlichungsnummer: WO99002024

(56) Entgegenhaltungen:
- WO-A-97/18697
- US-A- 5 559 727

## Beschreibung

Die Erfindung bezieht sich auf ein Verfahren und eine Vorrichtung zur Messung der Höhenposition von Objektkanten von Bauelementen.

Bei der automatischen Bestückung von Leiterplatten oder Keramiksubstraten mit SMD-Bauelementen (SMD = Surface Mounted Device) werden die einzelnen Bauelemente mittels eines Bestückkopfes aus einem Magazin oder einer Zuführeinrichtung entnommen und dann in einer vorgegebenen Lage auf der Leiterplatte oder dem Keramiksubstrat positioniert. Da die Bauelemente im Magazin oder in der Abholposition einer Zuführeinrichtung eine Lagetoleranz von etwa einem Millimeter aufweisen, auf der Leiterplatte oder dem Keramiksubstrat aber mit hoher Genauigkeit positioniert werden müssen, ist eine automatische Lageerkennung und Korrektur erforderlich. Ferner muß insbesondere bei hochpoligen SMD-Bauelementen die Teilung und die Koplanarität, das heißt die gleichmäßige Höhenposition der Anschlüsse überprüft werden. Eine derartige Überprüfung ist beispielsweise auch bei der Herstellung der SMD-Bauelemente als Qualitätskontrolle durchzuführen.

Bekannte Anordnungen zur Lageerkennung und Teilungsprüfung der Anschlüsse von Bauelementen bilden über ein Objektiv das Bauelement oder Ausschnitte des Bauelements auf eine flächenhafte CCD-Kamera ab und ermitteln über digitale Bildverarbeitung die Lage der Bauelementanschlüsse sowie die Teilung der Anschlüsse.

Aus US 5 440 391 ist für die Koplanaritätsmessung ein Triangulationsverfahren bekannt, bei dem die Höhenlage eines Anschlusses eines SMD-Bauelements dadurch bestimmt wird, daß der Anschluß mit Laserlicht aus zwei Richtungen beleuchtet wird und die beiden Schattenwürfe des Anschlusses mit CCD-Kameras detektiert werden. In einer den Kameras nachgeschalteten Bildauswerteeinheit wird daraus die Höhenlage der Anschlüsse bestimmt. Bei einer unzulässigen Abweichung der Koplanarität, die dazu führen würde, daß nicht alle Anschlüsse beim Aufsetzen auf die Leiterplatte einen Kontakt ergeben würden, kann das fehlerhafte Bauelement auf diese Art und Weise identifiziert und aus dem Bestückprozeß entfernt werden. Nachteilig bei diesem Verfahren ist die hohe Sensitivität der Reflexionen des Laserlichtes auf die Oberflächenbeschaffenheit der Anschlüsse, die zu Fehlmessungen führt.

Aus WO 93/19577 ist ein Schattenwurfverfahren zur Koplanaritätsmessung von Bauelementen bekannt. Dabei werden die Anschlüsse im Durchlicht beleuchtet und das Schattenbild des Anschlußendes eines SMD-Bauelementes auf einen Sensor projiziert. Die optische Achse der Abbildung besitzt zum horizontal angeordneten Objekt einen definierten Winkel ungleich 90°. Aus dem Winkel, dem Abstand des Anschlusses zum Sensor und der Position des Schattenbildes auf dem Sensor läßt sich die Höhenlage des Anschlusses berechnen. Aufgrund unterschiedlicher Bauelementgröße und daraus resultierender unterschiedlicher Bauelementposition in der Anordnung ergeben sich bei diesem Verfahren unscharfe Abbildungen des Schattens der Anschlüsse auf dem Sensor. Außerdem kann sich dabei die Position des Schattens auf dem Sensor verschieben, wenn das Bauelement weiter vom Sensor entfernt ist, so daß die Auswertung der Höhenposition erschwert wird.
Aus US 4 875 779 ist ein abbildendes Verfahren zur Koplanaritätsmessung von Anschlüssen von Bauelementen bekannt. Dazu werden die Anschlüsse auf einer Referenzfläche aufgesetzt und der Aufsetzbereich wird beleuchtet. Bei mangelnder Koplanarität entsteht ein Spalt zwischen der Referenzfläche und dem Anschluß, dieser Spalt wird auf einen Sensor abgebildet und in einer nachgeschalteten Bildauswerteeinheit zur Bestimmung der Koplanarität ausgewertet. Das Aufsetzen auf die Referenzfläche führt zu einem unerwünschten Zeitverlust im Bestückprozeß und zusätzlich führt die Anwesenheit einer Referenzfläche zu aufwendigen und teuren Konstruktionen beispielsweise am Bestückkopf. Durch die beschriebene Abbildung auf den Sensor ist außerdem nur eine geringe Schärfentiefe zu erzielen, so daß unterschiedlich große Bauelemente vor der Messung aufwendig an die Stelle der optimalen Abbildung positioniert werden müssen.

US-A-559 727 offenbart ein Verfahren und eine Vorrichtung zur Bestimmung der Position eines Bauelements an einer Aufnahmevorrichtung mittels telezentrischer Abbildung.

Es ist die Aufgabe der Erfindung, ein Verfahren und eine Vorrichtung zur Koplanaritätsmessung von Anschlüssen an Bauelementen zu entwickeln, die für unterschiedlich große Bauelemente ein auswertbares Schattenbild der Anschlüsse erzeugt, ohne die Oberflächensensitivität des Triangulationsverfahrens aufzuweisen.

Die Aufgabe wird erfindungsgemäß durch ein Verfahren und eine Vorrichtung mit den kennzeichnenden Merkmalen der Ansprüche 1 und 10 gelöst.

Durch das erfindungsgemäße Verfahren werden in vorteilhafter Weise die Schatten der Anschlüsse von Bauelementen auch dann auswertbar auf dem Sensor abgebildet, wenn sich die Position der Anschlüsse in einem vorgegebenen Bereich zwischen Linse und Kollimator verändert. Beim bekannten direkten Schattenwurfverfahren werden scharfe, auswertbare Schatten erzielt, wenn sich das Bauelement in unmittelbarer Nähe des Sensors befindet. Die Abbildung bleibt für die Auswertung ausreichend scharf, wenn die Anschlüsse innerhalb eines erlaubten Bereiches von dem Sensor entfernt sind. Durch das erfindungsgemäße Verfahren wird die Länge dieses Bereiches größenordnungsmäßig verdoppelt, da sich der Bereich, in dem sich eine auswertbare Abbildung des Schattens ergibt, vom optimalen Abbildungspunkt nun sowohl vom Sensor weg als auch in Richtung des Sensors erstreckt. Daher lassen sich unterschiedlich große Bauelemente vermessen.

Ein weiterer Vorteil bei Verwendung des erfindungsgemäßen Verfahrens besteht darin, daß sich bei der benutzten telezentrischen Abbildung die Position des abgebildeten Schattens auf dem Sensor nicht verändert, auch wenn die Anschlüsse vom optimalen Abbildungspunkt entfernt positioniert sind.

Weitere vorteilhafte Ausführungen sind in den Unteransprüchen geschildert. So ist es beispielsweise vorteilhaft, die Anschlüsse durch die gewählte telezentrische Abbildung vergrößert auf dem Sensor abbilden zu können, um auch kleine Strukturen noch ausreichend auflösen zu können.

Des weiteren ist es vorteilhaft, wie in Anspruch 14 beschrieben, durch die erfindungsgemäße größere Entfernung von Sensor und Bauelement den Sensor von Umgebungseinflüssen abkapseln zu können, um eine größere Unabhängigkeit gegenüber beispielsweise Staub zu erzielen. Verschmutzungen auf der in Richtung der optischen Achse lichtdurchlässigen Kapselung stören nur geringfügig die Abbildungseigenschaften.

Mit Hilfe von in der Zeichnung dargestellten Ausführungsbeispielen wird die Erfindung näher erläutert.

Dabei zeigen
Figur 1 schematisch eine Seitenansicht einer Vorrichtung zur Durchführung des Verfahrens, wobei die Anschlüsse aus zwei unterschiedlichen Winkeln beleuchtet werden,
Figur 2 eine schematische Seitenansicht einer Vorrichtung zur Durchführung des Verfahrens, bei dem die Anschlüsse nur mit einer Lichtquelle beleuchtet werden,
Figur 3 eine schematische Draufsicht auf eine Vorrichtung zur Durchführung des Verfahrens mit nur einer Lichtquelle und
Figur 4 einen schematischen Querschnitt durch einen Sensor zur Koplanaritätsmessung.

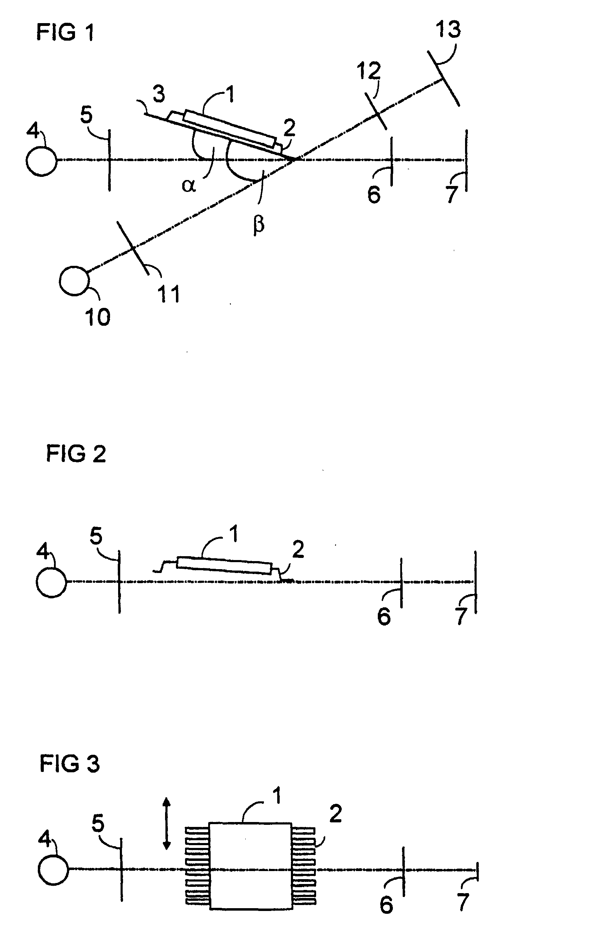

In Figur 1 ist dargestellt, wie ein Bauelement 1 mit mehreren, in Richtung einer Objekthorizontalen 3 liegenden Anschlüssen 2 beleuchtet und abgebildet wird. Das von einer Lichtquelle 4 ausgehende Strahlenbündel wird dabei beispielsweise durch einen Kollimator 5 in paralleles Licht umgewandelt, welches die Anschlüsse 2 des Bauelementes 1 beleuchtet. Eine Linse 6 bildet den Schatten des Anschlusses 2 auf einen Zeilensensor 7 ab. Neben dieser Beleuchtung unter einem Winkel α zur Objekthorizontalen 3 ist eine weitere Beleuchtung unter einem zweiten Winkel β zur Objekthorizontalen 3 vorgesehen. Dabei wird ebenfalls das Strahlenbündel, das von einer zweiten Lichtquelle 10 ausgeht, durch einen zweiten Kollimator 11 in paralleles Licht umgewandelt und der Anschluß 2 durch eine zweite Linse 12 auf einem zweiten Zeilensensor 13 abgebildet. Mit Hilfe einer in der Zeichnung nicht dargestellten Bildauswerteeinheit lassen sich die Abbildungen auf dem Zeilensensor 7 und dem zweiten Zeilensensor 13 so weiterverarbeiten, daß die Höhenlage des Anschlusses 2 berechnet werden kann. Außerdem läßt sich mit diesem Verfahren die Entfernung der Anschlüsse 2 vom Sensor 7 und vom zweiten Sensor 13 bestimmen.

In Figur 2 ist ein Verfahren dargestellt, das bei geringen Winkeln (bis ca. 10°) zwischen der Objekthorizontalen 3 und der optischen Achse mit nur einer Beleuchtung auskommt. Dabei wird ebenfalls das von einer Lichtquelle 4 ausgehende Strahlenbündel durch einen Kollimator 5 in paralleles Licht umgewandelt und der Schatten des Anschlusses 2 durch eine Linse 6 auf einen Zeilensensor 7 abgebildet. Durch den geringen Winkel ist sichergestellt, daß eine veränderte Höhenlage der Anschlüsse 2 sich in eine veränderte Höhenposition auf dem Sensor 7 umsetzt. Um alle Anschlüsse 2 zu vermessen, wird, wie in Figur 3 dargestellt, die Position des Bauelementes 1 zur optischen Achse verschoben, was entweder durch eine Bewegung des Bauelementes oder der Beleuchtungsvorrichtung geschehen kann. Befinden sich die abzubildenden Objektkanten der Anschlüsse 2 nicht am Punkt der optimalen Abbildung zwischen Linse 6 und Kollimator 5, so ergibt sich auf dem Sensor 7 ein breiter Hell-Dunkel-Übergang als Kante des Schattens. Die vertikale Position, bei der die mittlere Helligkeit des Hell-Dunkel-Übergangs detektiert wird, ändert sich beim erfindungsgemäßen Verfahren allerdings nur unwesentlich in Abhängigkeit von der Entfernung der Anschlüsse 2 vom optimalen Abbildungspunkt.

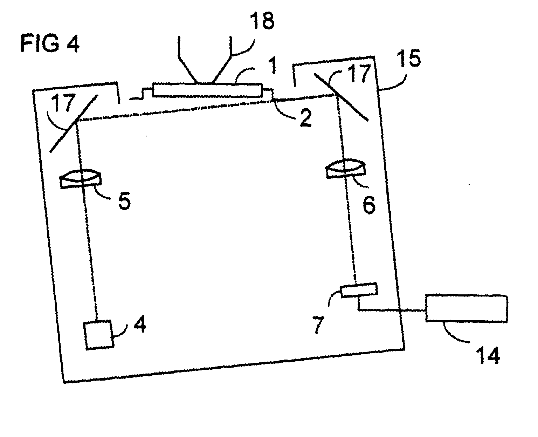

In Figur 4 ist beispielhaft eine Vorrichtung zur Durchführung des Verfahrens dargestellt. Diese Vorrichtung läßt sich beispielsweise als separate Station in Bestückautomaten oder Einrichtungen zur Qualitätskontrolle anbringen, oder auch in Bestückautomaten am Bestückkopf befestigen. In einem Gehäuse 15 befindet sich eine Lichtquelle 4 (beispielsweise eine infrarot emittierende Leucht- oder Laserdiode), deren Strahlenbündel durch einen Kollimator 5 in paralleles Licht umgewandelt wird. Das Licht wird durch einen Spiegel 17 umgelenkt, beleuchtet den Anschluß 2 eines Bauelementes 1, welches an einer Saugpipette 18 eines nicht dargestellten Bestückkopfes befestigt ist, wird durch einen weiteren Spiegel 17 umgelenkt auf eine Linse 6, die den Schatten des Anschlusses 2 auf dem Ze lensensor 7 abbildet. Dem Zeilensensor 7 ist eine Bildauswerteeinheit 14 nachgeschaltet, mit deren Hilfe die Höhenlage des Anschlusses 2 bestimmt werden kann. Anstelle des Zeilensensors 7 kann auch ein positionsempfindlicher Detektor (position sensitive detector: PSD) eingesetzt werden. Der Zeilensensor 7 kann durch eine zusätzliche Kapselung, welche in Richtung der optischen Achse lichtdurchlässig ausgeführt ist, von den Einflüssen der Umgebung (Staub, Verschmutzungen) geschützt werden. Die Qualität der Abbildung wird gegenüber dem direkten Schattenwurfverfahren durch Verschmutzungen auf der lichtdurchlässigen Kapselung nur vernachlässigbar beeinträchtigt.

Die Anordnung ist in einem Gehäuse 15 angeordnet, welches durch einen nicht dargestellten Antrieb so bewegt wird, daß alle in einer Reihe liegenden Anschlüsse 2 des Bauelementes 1 nacheinander auf dem Zeilensensor 7 abgebildet werden und in der Bildauswerteeinheit 14 die Koplanaritätsprüfung erfolgt.

Durch die horizontale Bewegung des Bauelementes 1 senkrecht zur optischen Achse läßt sich auch der Abstand der Anschlüsse 2 zueinander messen und dadurch eine sogenannte Teilungsprüfung durchführen. Die Anordnung liefert eine 4σ-Genauigkeit der Höhenpositionsbestimmung von ca. 6 µm, wenn sich die Anschlüsse 2 an einer Position in einem 26 mm langen Bereich zwischen Linse 6 und Kollimator 5 (Brennweite jeweils 80 mm) befinden. Damit läßt sich die Höhenlage der Anschlüsse von unterschiedlich großen Bauelementen (üblicherweise 6 mm bis 60 mm) in dieser Vorrichtung ohne aufwendige Justierung bestimmen. Die Ausdehnung des Bereichs, in dem die Anschlüsse 2 positioniert werden können, damit ihr Schatten auswertbar abgebildet wird, ist gegenüber dem Schattenwurfverfahren größenordnungsmäßig verdoppelt worden. Das Bauelement 1 kann aus seiner optimalen Abbildungsposition sowohl in Richtung des Sensors 7 als auch vom Sensor 7 weg bewegt werden, was beim direkten Schattenwurfverfahren aufgrund der dortigen Position des Bauelementes 1 direkt am Sensor 7 nicht möglich ist.

## Patentansprüche

1. Verfahren zur Messung der Höhenlage einer Objektkante (2) eines Bauelements (1),
bei dem die senkrecht zur optischen Achse angeordneten Objektkante (2) durch parallele Lichtstrahlen von mindestens einer Lichtquelle (4) beleuchtet wird,
der Schatten der Objektkante (2) durch eine Linse (6) telezentrisch auf einen Sensor (7) abgebildet wird, wobei der Sensor (7) als Zeilensensor (7) ausgebildet ist, der senkrecht zu der Objektkante (2) in der Abbildung und senkrecht zu einem auf ihn gerichteten Teil der optischen Achse angeordnet ist, und in einer dem Sensor (7) nachgeschalteten Bildauswerteeinheit (14) die Höhenlage der Objektkante (2) ermittelt wird.

2. Verfahren zur Messung der Höhenlage von Objektkanten nach Anspruch 1,
**dadurch gekennzeichnet,**
**daß** die Objektkanten die Kanten der Anschlüsse (2) der Bauelemente (1) sind und mit dem Verfahren die Koplanarität der Anschlüsse (2) untersucht wird.

3. Verfahren zur Messung der Höhenlage von Objektkanten (2) nach einem der Ansprüche 1 oder 2,
**dadurch gekennzeichnet,**
**daß** die parallelen Lichtstrahlen durch einen im Strahlengang zwischen Lichtquelle (4) und Objektkante (2) angeordneten Kollimator (5) erzeugt werden.

4. Verfahren zur Messung der Höhenlage von Objektkanten (2) nach Anspruch 1 bis 3,
**gekennzeichnet durch**
einen kleinen Winkel zwischen den Lichtstrahlen und einer Objekthorizontalen (3) des Bauelementes.

5. Verfahren zur Messung der Höhenlage von Objektkanten (2) nach Anspruch 1 bis 3,
**dadurch gekennzeichnet,**
**daß** ein zusätzliches Schattenbild der Objektkanten (2) des Bauelementes (1) durch Beleuchtung mit parallelem Licht aus einer zweiten Lichtquelle (10) mit einem zweitem Kollimator (11) und Abbildung durch eine zweite Linse (12) auf einen zweiten Sensor (13) erzeugt wird, wobei sich die Winkel (α,β) zwischen der Objekthorizontalen (3) des Bauelementes und den jeweiligen Lichtstrahlen unterscheiden und
**daß** aus den beiden Abbildungen auf die Sensoren (7,13) in der Bildauswerteeinrichtung (14) die Höhenlage der Objektkanten (2) überprüft wird.

6. Verfahren zur Messung der Höhenlage von Objektkanten (2) nach Anspruch 5,
**dadurch gekennzeichnet,**
**daß** zusätzlich die Entfernung der Objektkanten (2) vom Sensor (7) bestimmt wird.

7. Verfahren zur Messung der Höhenlage von Objektkanten (2) nach einem der Ansprüche 1 bis 6,
**dadurch gekennzeichnet,**
**daß** die Position des Bauelementes (1) zur optischen Achse verändert wird, um verschiedene Objektkanten (2) zu vermessen.

8. Verfahren zur Messung der Höhenlage von Objektkanten (2) nach einem der Ansprüche 1 bis 7,
**dadurch gekennzeichnet,**
**daß** der Abstand zwischen verschiedenen Objektkanten (2) gemessen wird.

9. Verfahren zur Messung der Höhenlage von Objektkanten (2) nach einem der Ansprüche 1 bis 8,
**dadurch gekennzeichnet,**
**daß** die Schatten der Objektkanten (2) vergrößert auf dem Sensor (7) abgebildet werden.

10. Vorrichtung zur Messung der Höhenlage der Objektkante (2) eines Bauelements (1)
mit mindestens einer Lichtquelle (4) zum Beleuchten der Objektkante (2),
mit mindestens einem Sensor (7) mit nachgeschalteter Bildauswerteeinheit (14),
mit mindestens einem Kollimator (5) und mindestens einer Linse (6), die so im Strahlengang angeordnet sind, daß die senkrecht zur optischen Achse angeordnete Objektkante (2) des Bauelements (1) mit parallelem Licht beleuchtet wird und der Schatten der Objektkante (2) telezentrisch auf den Sensor (7) abgebildet wird,
**dadurch gekennzeichnet,**
**daß** der Sensor (7) als Zeilensensor ausgebildet ist, der senkrecht zu einem auf ihn gerichteten Teil der optischen Achse und senkrecht zu der Objektkante (2) in der Abbildung angeordnet ist (7).

11. Vorrichtung zur Messung der Höhenlage von Objektkanten (2) nach Anspruch 10,
**dadurch gekennzeichnet,**
**daß** eine zweite Lichtquelle (10) , ein zweiter Kollimator (11) , eine zweite Linse (12) und ein zweiter Sensor (13), der ebenfalls mit der Bildauswerteeinheit (14) verbunden ist, derart angeordnet sind, daß die Objektkanten (2) aus einer zweiten Richtung beleuchtet und abgebildet werden.

12. Vorrichtung zur Messung der Höhenlage von Objektkanten (2) nach Anspruch 10 oder 11,
**dadurch gekennzeichnet,**
**daß** die Vorrichtung in einem Gehäuse (15) untergebracht ist.

13. Vorrichtung zur Messung der Höhenlage von Objektkanten (2) nach einem der Ansprüche 10, 11 oder 12,
**dadurch gekennzeichnet,**
**daß** das Gehäuse (15) mit einem Antrieb zum Verändern der Position der Vorrichtung relativ zum Bauelement (1) versehen ist, um verschiedene Objektkanten (2) des Bauelementes (1) auf dem Sensor (7) abzubilden.

14. Vorrichtung zur Messung der Höhenlage von Objektkanten (2) nach einem der Ansprüche 10 bis 13,
**dadurch gekennzeichnet,**
**daß** um den Sensor (7) eine Kapselung angeordnet ist, die in Richtung der optischen Achse lichtdurchlässig ist.

15. Vorrichtung zur Messung der Höhenlage von Objektkanten (2) nach einem der Ansprüche 10 bis 14,
**gekennzeichnet durch**
einen senkrecht zur optischen Achse und senkrecht zu den Objektkanten (2) angeordneten positionsempfindlichen Sensor als Sensor (7).

16. Vorrichtung zur Messung der Höhenlage von Objektkanten (2) nach einem der Ansprüche 10 bis 15,
**gekennzeichnet durch**
eine infrarot emittierende Leuchtdiode als Lichtquelle (4).

17. Vorrichtung zur Messung der Höhenlage von Objektkanten (2) nach einem der Ansprüche 10 bis 15,
**gekennzeichnet durch**
eine infrarot emittierende Laserdiode als Lichtquelle (4).

## Claims

1. Method for measuring the height at which an object edge (2) of a component (1) is positioned, in which the object edge (2), which is arranged perpendicular to the optical axis, is illuminated by parallel light beams of at least one light source (4), the shadow of the object edge (2) is imaged telecentrically by means of a lens (6) on a sensor (7), the sensor (7) being constructed as a line sensor (7) which is arranged perpendicular to the object edge (2) in the image and perpendicular to a part of the optical axis facing towards it, and the height at which the object edge (2) is positioned is determined in an image evaluating unit (14) connected downstream of the sensor (7).

2. Method for measuring the height at which object edges are positioned according to Claim 1, **characterized in that** the object edges are the edges of the terminals (2) of the components (1), and the coplanarity of the terminals (2) is investigated using the method.

3. Method for measuring the height at which object edges (2) are positioned according to one of Claims 1 or 2, **characterized in that** the parallel light beams are produced by a collimator (5) arranged in the beam path between the light source (4) and object edge (2).

4. Method for measuring the height at which object edges (2) are positioned according to Claims 1 to 3, **characterized by** a small angle between the light beams and an object horizontal (3) of the component.

5. Method for measuring the height at which object edges (2) are positioned according to Claims 1 to 3, **characterized in that** an additional shadow image of the object edges (2) of the component (1) is produced by illumination with parallel light from a second light source (10) with the aid of a second collimator (11), and imaging by means of a second lens (12) on a second sensor (13), the angles (α, β) between the object horizontal (3) of the component and the respective light beams being different, and **in that** the height at which the object edges (2) are positioned is checked from the two images on the sensors (7, 13) in the image evaluating device (14).

6. Method for measuring the height at which object edges (2) are positioned according to Claim 5, **characterized in that** the distance of the object edges (2) from the sensor (7) is additionally determined.

7. Method for measuring the height at which object edges (2) are positioned according to one of Claims 1 to 6, **characterized in that** the position of the component (1) is varied relative to the optical axis in order to measure different object edges (2).

8. Method for measuring the height at which object edges (2) are positioned according to one of Claims 1 to 7, **characterized in that** the spacing between different object edges (2) is measured.

9. Method for measuring the height at which object edges (2) are positioned according to one of Claims 1 to 8, **characterized in that** the shadows of the object edges (2) are imaged in an enlarged fashion on the sensor (7).

10. Device for measuring the height at which the object edge (2) of a component (1) is positioned, having at least one light source (4) for illuminating the object edge (2), having at least one sensor (7) with an image evaluating unit (14) connected downstream, and having at least one collimator (5) and at least one lens (6) which are arranged in the beam path such that the object edge (2) of the component (1), which edge is arranged perpendicular to the optical axis, is illuminated with parallel light, and the shadow of the object edge (2) is imaged telecentrically on the sensor (7), **characterized in that** the sensor (7) is constructed as a line sensor which is arranged perpendicular to a part of the optical axis facing towards it and perpendicular to the object edge (2) in the image.

11. Device for measuring the height at which object edges (2) are positioned according to Claim 10, **characterized in that** a second light source (10), a second collimator (11), a second lens (12) and a second sensor (13), which is likewise connected to the image evaluating unit (14), are arranged in such a way that the object edges (2) are illuminated and imaged from a second direction.

12. Device for measuring the height at which object edges (2) are positioned according to Claim 10 or 11, **characterized in that** the device is accommodated in a housing (15).

13. Device for measuring the height at which object edges (2) are positioned according to one of Claims 10, 11 or 12, **characterized in that** the housing (15) is provided with a drive for varying the position of the device relative to the component (1), in order to image different object edges (2) of the component (1) on the sensor (7).

14. Device for measuring the height at which object edges (2) are positioned according to one of Claims 10 to 13, **characterized in that** there is arranged around the sensor (7) an encapsulation which is transparent to light in the direction of the optical axis.

15. Device for measuring the height at which object edges (2) are positioned according to one of Claims 10 to 14, **characterized by** a position sensitive detector arranged perpendicular to the optical axis and perpendicular to the object edges (2) as sensor (7).

16. Device for measuring the height at which object edges (2) are positioned according to one of Claims 10 to 15, **characterized by** an infrared-emitting light-emitting diode as light source (4).

17. Device for measuring the height at which object edges (2) are positioned according to one of Claims 10 to 15, **characterized by** an infrared-emitting laser diode as light source (4).

## Revendications

1. Procédé pour la mesure de la position en hauteur d'un bord d'objet (2) d'un composant (1), dans lequel le bord d'objet (2) disposé perpendiculairement à l'axe optique est éclairé par des rayons lumineux parallèles d'au moins une source de lumière (4), l'ombre du bord d'objet (2) étant formée télécentriquement sur un capteur (7) par une lentille (6), le capteur (7) étant configuré comme capteur à lignes (7) qui, dans l'image formée, est disposé perpendiculairement au bord de l'objet et perpendiculairement à une partie de l'axe optique tournée vers lui, la position en hauteur du bord d'objet (2) étant calculée dans une unité (14) d'évaluation d'image raccordée en aval du capteur (7).

2. Procédé pour la mesure de la position en hauteur de bords d'objet selon la revendication 1, **caractérisé en ce que** les bords d'objet sont les bords des raccordements (2) du composant (1), le procédé examinant la coplanéité du raccordement (2).

3. Procédé pour la mesure de la position en hauteur de bords d'objet (2) selon l'une des revendications 1 ou 2, **caractérisé en ce que** les rayons lumineux parallèles sont créés par un collimateur (5) disposé dans le parcours des rayons entre la source de lumière (14) et le bord d'objet (2).

4. Procédé pour la mesure de la position en hauteur de bords d'objet (2) selon la revendication 1 à 3, **caractérisé par** un petit angle entre les rayons lumineux et une horizontale d'objet (3) du composant.

5. Procédé pour la mesure de la position en hauteur de bords d'objet (2) selon la revendication 1 à 3, **caractérisé en ce qu'**une image supplémentaire de l'ombre des bords d'objet (2) du composant (1) est créée par éclairage par une lumière parallèle provenant d'une deuxième source de lumière (10) avec un deuxième collimateur (11), et formation d'une image par une deuxième lentille (12) sur un deuxième capteur (13), les angles (α, β) entre l'horizontale d'objet (3) du composant et le rayon lumineux concerné étant différent, et **en ce que** la position en hauteur des bords d'objet (2) est vérifiée dans le dispositif (14) d'évaluation d'image à partir des deux images formées sur les capteurs (7, 13).

6. Procédé pour la mesure de la position en hauteur de bords d'objet (2) selon la revendication 5, **caractérisé en ce que** l'on détermine en supplément la distance des bords d'objet (2) par rapport au capteur (7).

7. Procédé pour la mesure de la position en hauteur de bords d'objet (2) selon la revendication 1 à 6, **caractérisé en ce que** la position du composant (1) par rapport à l'axe optique est modifiée pour mesurer différents bords d'objet (2).

8. Procédé pour la mesure de la position en hauteur de bords d'objet (2) selon l'une des revendications 1 à 7, **caractérisé en ce que** la distance entre différents bords d'objet (2) est mesurée.

9. Procédé pour la mesure de la position en hauteur de bords d'objet (2) selon l'une des revendications 1 à 8, **caractérisé en ce que** les ombres des bords d'objet (2) sont formées sur le capteur (7) de manière à être agrandies.

10. Dispositif pour la mesure de la position en hauteur de bords d'objet (2) d'un composant (1),
avec au moins une source de lumière pour l'éclairage du bord d'objet (2),
avec au moins un capteur (7) en aval duquel est raccordée une unité (14) d'évaluation d'image,
avec au moins un collimateur (5) et au moins une lentille (6) qui sont disposés dans le parcours des rayons de telle sorte que le bord d'objet (2) du composant disposé perpendiculairement à l'axe optique soit éclairé par de la lumière parallèle et que l'ombre du bord d'objet (2) soit formée télécentriquement sur le capteur (7),
**caractérisé en ce que**
le capteur (7) est configuré comme capteur à lignes qui est disposé perpendiculairement à une partie dirigée vers lui de l'axe optique et perpendiculairement au bord d'objet (2) de l'image formée.

11. Dispositif pour la mesure de la position en hauteur de bords d'objet (2) selon la revendication 10, **caractérisé en ce qu'**une deuxième source de lumière (10), un deuxième collimateur (11), une deuxième lentille (12) et un deuxième capteur (13) qui est également relié à l'unité (14) d'évaluation d'image sont disposés de telle sorte que les bords d'objet (2) sont éclairés et leur image formée dans une deuxième direction.

12. Dispositif pour la mesure de la position en hauteur de bords d'objet (2) selon la revendication 10 ou 11, **caractérisé en ce que** le dispositif est installé dans un boîtier (15).

13. Dispositif pour la mesure de la position en hauteur de bords d'objet (2) selon l'une des revendication 10, 11 ou 12, **caractérisé en ce que** le boîtier (15) est doté d'un entraînement pour modifier la position du dispositif par rapport au composant (1), pour former l'image de différents bords d'objet (12) du composant (1) sur le capteur (7).

14. Dispositif pour la mesure de la position en hauteur de bords d'objet (2) selon l'une des revendications 10 à 13, **caractérisé en ce qu'**une encapsulation qui est transparente à la lumière dans la direction de l'axe optique est disposée autour du capteur (7).

15. Dispositif pour la mesure de la position en hauteur de bords d'objet (2) selon les revendications 10 à 14, **caractérisé par** un capteur sensible à la position, disposé perpendiculairement à l'axe optique et perpendiculairement aux bords d'objet (2), comme capteur (7).

16. Dispositif pour la mesure de la position en hauteur de bords d'objet (2) selon l'une des revendications 10 à 15, **caractérisé par** une diode luminescente émettant dans l'infrarouge comme source de lumière (4).

17. Dispositif pour la mesure de la position en hauteur de bords d'objet (2) selon l'une des revendications 10 à 15, **caractérisé par** une diode laser émettant dans l'infrarouge comme source de lumière (4).
